Europäisches Patentamt

European Patent Office

Office européen des brevets

(19)

(11) **EP 1 216 559 B1**

(12) **EUROPÄISCHE PATENTSCHRIFT**

(45) Veröffentlichungstag und Bekanntmachung des Hinweises auf die Patenterteilung:
**22.12.2004 Patentblatt 2004/52**

(51) Int Cl.$^7$: **H04L 27/36**, H03F 1/32

(86) Internationale Anmeldenummer:
**PCT/EP2000/006078**

(21) Anmeldenummer: 00943944.9

(22) Anmeldetag: **29.06.2000**

(87) Internationale Veröffentlichungsnummer:
**WO 2001/024467 (05.04.2001 Gazette 2001/14)**

(54) **VERFAHREN ZUM EINSTELLEN EINES PHASENWINKELS EINES PHASENSCHIEBERS EINER SENDEEINRICHTUNG**

METHOD FOR ADJUSTING A PHASE ANGLE OF A PHASE MODIFIER OF A TRANSMITTING DEVICE

PROCEDE POUR LE REGLAGE D'UN ANGLE DE PHASE D'UN DEPHASEUR D'UN EMETTEUR

(84) Benannte Vertragsstaaten:
**DE FR GB IT**

(30) Priorität: **29.09.1999 DE 19946669**

(43) Veröffentlichungstag der Anmeldung:
**26.06.2002 Patentblatt 2002/26**

(73) Patentinhaber: **Rohde & Schwarz GmbH & Co. KG 81671 München (DE)**

(72) Erfinder: **LIPP, Friedrich A-5322 Hof bei Salzburg (AT)**

(74) Vertreter: **Körfer, Thomas, Dipl.-Phys. et al Mitscherlich & Partner, Patent- und Rechtsanwälte, Sonnenstrasse 33 80331 München (DE)**

(56) Entgegenhaltungen:
**WO-A-00/25421      WO-A-98/00908**
**WO-A-99/04486      US-A- 5 793 817**
**US-A- 5 894 496**

**Beschreibung**

Die Erfindung betrifft ein Verfahren zum Einstellen eines Phasenwinkels eines Phasenschiebers einer Sendeeinrichtung. Die Sendeeinrichtung umfaßt einen Quadraturmodulator und einen Leistungsverstärker, der durch eine sogenannte kartesische Rückkopplungsschleife (cartesian feedback) mit einem Quadraturdemodulator linearisiert ist.

Ein Verfahren nach dem Oberbegriff des Anspruchs 1 geht beispielsweise aus der EP 0 706 259 Al hervor. Bei der aus dieser Druckschrift hervorgehenden Sendeeinrichtung wird ein Basisband-Eingangssignal über zwei Differenzverstärker einem Quadraturmodulator zugeführt, welcher eine Quadraturmodulation der Inphase-Komponente und der Quadraturphase-Komponente des komplexen Eingangssignals vornimmt. Die Leistungsverstärkung erfolgt in einem dem Quadraturmodulator nachgeschalteten Leistungsverstärker. Zum Ausgleich der Nichtlinearität dieses Leistungsverstärkers ist eine Rückkopplungsschleife vorgesehen, die im allgemeinen als cartesian feedback bezeichnet wird. In dieser Rückkopplungsschleife befindet sich ein Quadraturdemodulator, der das rückgekoppelte Signal in eine rückgekoppelte Inphase-Komponente und eine rückgekoppelte Quadraturphase-Komponente zerlegt. Die rückgekoppelte Inphase-Komponente wird zusammen mit der Inphase-Komponente des Eingangssignals einem dem Quadraturmodulator vorgeschalteten ersten Differenzverstärker zugeführt. Entsprechend wird die rückgekoppelte Quadraturphase-Komponente zusammen mit der Quadraturphase-Komponente des Eingangssignals einem zweiten Differenzverstärkers zugeführt. Dadurch werden die Nichtlinearitäten des Leistungssverstärkers über das rückgekoppelte Signal ausgeglichen.

Bei einer nach dem cartesian-feedback-Verfahren arbeitenden Sendeeinrichtung ist es besonders wichtig, daß das rückgekoppelte Signal phasenrichtig eingekoppelt wird. Um dies zu erreichen wird das Signal eines lokalen Oszillators, welches für die Quadraturmodulation und Quadraturdemodulation benötigt wird, dem Quadraturdemodulator unter einem gegenüber dem Quadraturmodulator verschobenen Phasenwinkel zugeführt. Die Phasenverschiebung erfolgt in einem Phasenschieber, dessen Phasenwinkel eingestellt werden muß. Zur Einstellung des Phasenwinkels wird in der EP 0 706 259 Al ein Testbetrieb vorgeschlagen, bei welchem die Rückkopplungsschleife am Ausgang des Quadraturdemodulators unterbrochen wird. An den Eingang des Quadraturmodulators wird ein Testsignal angelegt und das Ausgangssignal des Quadraturdemodulators wird gemessen. Bei einem vorgegebenen Eingangssignal kann aus dem Realteil und dem Imaginärteil des Ausgangssignals des Quadraturdemodulators der einzustellende Phasenwinkel berechnet werden.

Nachteilig bei der in der EP 0 706 259 Al vorgeschlagenen Vorgehenssweise ist jedoch, daß die Rückkopplungsschleife zum Ermitteln des Phasenwinkels jedesmal geöffnet werden muß. Diese Verfahren mag geeignet sein, um den Phasenwinkel bei der Inbetriebnahme einmalig einzustellen. Bei der Anwendung einer nach dem Prinzip des cartesian feedback arbeitenden Sendeeinrichtung im Flugfunk, insbesondere beim nach dem VDL-Standard (VHL-digitial-link) im TDMA-Simplex-Betrieb arbeitenden digitalen Flugfunk, besteht jedoch die Notwendigkeit, den Phasenwinkel bei jedem Sendeintervall (Sendeburst) zu überprüfen und ggf. nachzujustieren. Dies ist mit dem aus der EP 0 706 259 Al hervorgehenden Verfahren aufgrund der zeitaufwendigen Auftrennung der Rückkopplungsschleife und des komplizierten Meßverfahrens nicht durchführbar.

Die WO 99/04486 A offenbart die gattungsbildenden Merkmale einer Sendeeinrichtung die durch eine sogenannte kartesische Rückkopplungseinrichtung linearisiert ist. Dabei erfolgt die Bildung der dort beschriebenen Fehlersignale an den beiden Komparatoren. Die Messung der Phasenlage des Fehlersignals erfolgt nach den Integratorschaltungen. Die Korrektur des Phasenunterschieds erfolgt durch eine Phasenschiebeeinrichtung durch eine Vorverzerrung des Eingangssignals vor dem Quadraturmodulator. Danach erfolgt die Kombination der beiden Fehlersignale und Aufmodulation einer Zwischenfrequenz, dann eine weitere Frequenzanhebung auf die eigentliche Sendefrequenz. Entsprechend umgekehrt wird dann mit dem Signal im Rückkopplungskreis verfahren. Die beiden dazu notwendigen Trägerfrequenzen werden von zwei Quellen zur Verfügung gestellt, deren Frequenzen jeweils über einen Signalverteiler auf die vier Modulations- bzw. Demodulationseinrichtungen aufgeteilt werden. Im weiteren deutet das Dokument an, daß die Vorrichtung zur Phasenregelung dazu in der Lage sein kann, sich mittels eines einfachen Algorithmus automatisch einzustellen, wenn eine sog. "initialising input sequence" von der Sendeeinrichtung benutzt wird.

Aus der US-A-5 894 496 ist ein weiterer Rückkopplungsverstärker bekannt. Der in dieser Druckschrift offenbarte kartesische Rückkopplungsverstärker hat keinen Phasenschieber, weder zur Vorverzerrung noch zur Einstellung der Phasenlage von Oszillatorsignalen.

Die WO 98/00908 A zeigt zwar einen Phasenschieber für das Oszillatorsignal für den Demodulator, jedoch wird der entsprechende Phasenkorrekturwert mittels Hüllkurvendetektion des Sendesignals bestimmt und nicht etwa über die Differenzverstärkerausgangssignale, d. h. die Fehlersignale des I- und Q-Pfades.

Ein weiteres Verfahren zur Korrektur des Phasenfehlers ist aus der WO 00/25421 A bekannt. Dieses Dokument ist jedoch erst am 4. Mai 2000, also nach dem Prioritätstag der vorliegenden Anmeldung, veröffentlicht worden und daher für die Prüfung der erfinderischen Tätigkeit nicht relevant.

Der Erfindung liegt deshalb die Aufgabe zu Grunde, ein Verfahren zum Einstellen eines Phasenwinkels eines Phasenschiebers einer Sendeeinrichtung mit einem Leistungsverstärker, welcher nach dem Prinzip des Cartesian Feedback linearisiert ist, anzugeben, welches bei jedem Sendeintervall eine Korrektur bzw. Nachstellung des Phasenwinkels ermöglicht und somit nicht nach dem Prinzip der Vorverzerrung des Eingangssignals arbeitet, wobei die sich ergebende Schaltungsarchitektur einfacher und unempfindlicher gegen elektromagnetische Einflüsse sein soll.

Die Aufgabe wird durch die kennzeichnenden Merkmale des Anspruchs 1 in Verbindung mit den gattungsbildenden Merkmalen gelöst.

Der Erfindung liegt die Erkenntnis zugrunde, daß durch Anlegen eines Eingangssignals mit einer vorgegebenen, konstanten Inphase-Komponente und einer vorgegebenen, konstanten Quadraturphase-Komponente sich eine Abweichung des Phasenwinkels relativ einfach ermitteln läßt. Dabei kann die Rückkopplungsschleife bestehend aus Quadraturmodulator, Leistungsverstärker und Quadraturdemodulator und den Differenzverstärkern geschlossen bleiben. Das Verfahren kann bei jedem Sendeintervall durchgeführt werden, da es nicht zeitaufwendig ist und keine Auftrennung der Rückkopplungsschleife erfordert.

Die Ansprüche 2 bis 8 betreffen vorteilhafte Weiterbildungen des erfindungsgemäßen Verfahrens.

Vorteilhaft kann das Anlegen eines Eingangssignals mit vorgegebener Inphase-Komponente (I = const.) und ohne Quadraturphase-Komponente (Q = 0) sowie das Messen der Quadraturphase-Komponente am Ausgang des Differenzverstärkers zu Beginn eines jeden Sendeintervalls erfolgen. Beim Umschalten vom Empfangsbetrieb zum Sendebetrieb ist es zu Beginn des Sendeintervalls ohnehin vorteilhaft.über beispielsweise drei Datensymbole hinweg ein Referenzsignal mit einer reinen Inphase-Komponente ohne Quadraturphase-Komponente anzulegen. Dieses Referenzsignal kann für die erfindungsgemäße Phasenbestimmung ohne zeitlichen Mehraufwand verwendet werden. Bei einem Eingangssignal ohne Quadraturphase-Komponente (Q = 0) tritt idealerweise am Ausgang des Differenzverstärkers in der Quadraturphase-Regelschleife keine Spannung auf. Wird an diesem Meßpunkt dennoch eine Spannung gemessen, so deutet dies auf einen Phasenfehler hin, welcher in dem nächsten Sendeunterbrechungs-Intervall bzw. Empfangsintervall korrigiert werden kann.

Der Phasenkorrekturwert kann aus der gemessenen Quadraturphase-Komponente ggf. unter Berücksichtigung der zusätzlich gemessenen Inphase-Komponente durch eine Arcus-Tangens-Beziehung unmittelbar bestimmt werden. Die den Meßwerten zugeordnete Phasenkorrekturwerte können in einem Speicher tabelliert sein (look-up-Tabelle) und ohne weitere Berechnung unmittelbar abgelesen werden. Eine alternative Möglichkeit zur Bestimmung des optimalen Phasenkorrekturwertes besteht in einem Versuchs- und Irrtumsverfahren, bei welchem der Phasenwinkel versuchsweise während eines Empfangsintervalls geringfügig verändert wird und in dem nachfolgenden Sendeintervall durch Messen der Quadraturphase-Komponente mit dem vorstehend beschriebenen Referenzsignal ermittelt wird, ob der neu eingestellte Phasenwinkel ein besseres Resultat erbringt. Ist dies der Fall, so wird der Phasenwinkel im nachfolgenden Empfangsintervall in diese Richtung weiter verändert. Erbringt der neu eingestellten Phasenwinkel eine Verschlechterung, so wird im nachfolgenden Empfangsintervall der Phasenwinkel auf den vorher eingestellten Wert zurückgestellt. Durch diesen Feinabgleich können geringfügige Phasenfluktationen, welche sich beispielsweise durch eine Temperaturdrift ergeben, im laufenden Betrieb nachkorrigiert werden.

Vor der erstmaligen Inbetriebnahme der Sendeeinrichtung ist es vorteilhaft, eine Voreinstellung des Phasenwinkels so vorzunehmen, daß sich eine minimale Ausgangsleistung ergibt. Für diesen Fall ergibt sich die maximale Eigendämpfung des Systems im Gegensatz zum umgekehrten Fall der maximalen Ausgangsleistung, bei welcher sich die maximale Mitkopplung des Systems ergibt. Das Signal der Rückkopplungsschleife wird in diesem Fall gedämpft.

Ein vereinfachtes Ausführungsbeispiel der Erfindung wird nachfolgend unter Bezugnahme auf die Zeichnung näher beschrieben. In der Zeichnung zeigen:

Fig. 1    ein Blockschaltbild eines Ausführungsbeispiels einer Sendeeinrichtung, welche sich für das erfindungsgemäße Verfahren eignet;

Fig. 2    ein Zeitdiagramm zur Erläuterung des erfindungsgemäßen Verfahrens;

Fig. 3    ein Flußdiagramm zur Erläuterung eines Ausführungsbeispiels des erfindungsgemäßen Verfahrens und

Fig. 4    ein Diagramm zur Erläuterung der Messung des Phasenkorrekturwinkels.

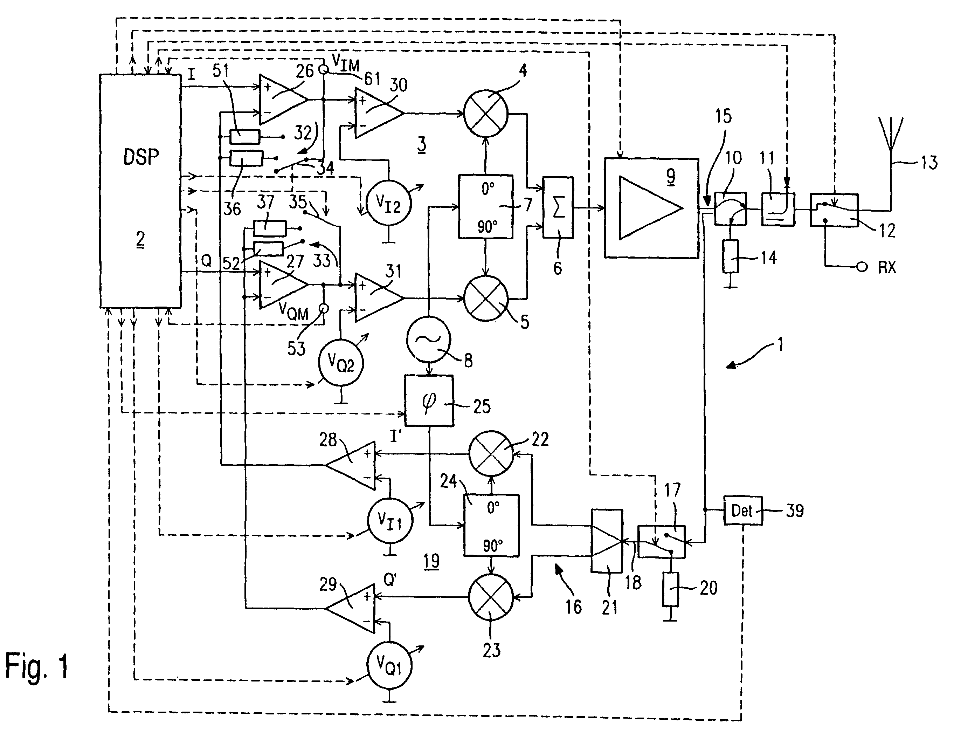

Fig. 1 zeigt eine zur Durchführung des erfindungsgemäßen Verfahrens geeignete Sendeeinrichtung 1 in einem prinzipiellen Blockschaltbild.

Ein digitaler Signalprozessor (DSP) 2 erzeugt ein komplexes Eingangssignal für einen Quadraturmodulator 3, der aus einem Inphase-Mischer 4, einem Quadraturphase-Mischer 5 und einem Summierer 6 sowie einem Phasenschieber 7 besteht. Das komplexe Eingangssignal besteht aus einer Inphase-Komponente I und einer Quadraturphase-Komponente Q, wobei die Inphasen-Komponente I dem Inphase-Mischer 4 und die Quadraturphase-Komponente Q dem Quadraturphase-Mischer 5 zugeführt wird. Dem Phasenschieber 7 wird das Ausgangssignal eines lokalen Oszillators 8 zugeführt, wobei der Phasenschieber 7 dieses Oszillatorsignal dem Inphase-Mischer 4 ohne Phasenverschiebung und dem Quadraturphase-Mischer 5 unter einer Phasenverschiebung von 90° zuführt.

Dem Quadraturmodulator 3 ist ein Leistungsverstärker 9 nachgeschaltet, der das quadraturmodulierte Signal entsprechend der Sendeleistung der Sendeeinrichtung 1 leistungsverstärkt und über einen Zirkulator 10, einen Leistungsdetektor 11 und einen Sende-Empfangsumschalter 12 einer Antenne 13 zuführt. Im in Fig. 1 dargestellten Ausführungsbeispiel dient der digitale Signalprozessor 2 gleichzeitig als Steuereinheit für die Sende-Empfangsumschaltung und steuert den Sende-Empfangsumschalter 12 so an, daß die Antenne 13 beim Sendebetrieb mit dem Leistungsverstärker 9 und beim Empfangsbetrieb mit einem als RX bezeichneten Empfänger verbunden ist. Um eine Rückkopplung eventuell reflektierter Sendeleistung in den Leistungsverstärker 9 zu vermeiden, dient der mit dem Abschlußwiderstand 14 verbundene Zirkulator 10.

In dem Signalpfad zwischen dem Leistungsverstärker 9 und der Antenne 13 befindet sich ein Auskoppler 15, der das Ausgangssignal des Leistungsverstärkers 9 in eine Rückkopplungsschleife 16 einkoppelt. In der Rückkopplungsschleife 16 befindet sich ein Umschalter 17, über welchen ein Eingang 18 eines Quadraturdemodulators 19 wahlweise mit dem Auskoppler 15 oder einem Abschlußwiderstand 20 verbindbar ist. Zwischen dem Auskoppler 15 und dem Umschalter 17 befindet sich ein logarithmischer Leistungsdetektor 39. Der Quadraturdemodulator 19 besteht aus einem Signalverteiler 21, der das Eingangssignal gleichmäßig auf einen Inphase-Mischer 22 und einen Quadraturphase-Mischer 23 verteilt. Ferner ist ein Phasenschieber 24 vorgesehen, dem das Ausgangssignal des lokalen Oszillators 8 über einen einstellbaren Phasenschieber 25 zugeführt wird. Der Phasenschieber 24 arbeitet wie der Phasenschieber 7 und führt dem Inphase-Mischer 22 ein nicht phasenverschobenes Oszillatorsignal und dem Quadraturphasen-Mischer 23 ein um 90° phasenverschobenes Oszillatorsignal zu, wobei das Oszillatorsignal vorher durch den Phasenverschieber 25 insgesamt um einen Phasenwinkel φ phasenverschoben wurde.

Am Ausgang des Inphase-Mischers 22 liegt eine rückgekoppelte Inphase-Komponente I' und am Ausgang des Quadraturphase-Mischers 23 liegt eine rückgekoppelte Quadraturphase-Komponente Q' vor. Die Inphase-Komponente I des Eingangssignals wird auf den (+)-Eingang eines ersten Differenzverstärkers 26 gegeben, während die rückgekoppelte Inphase-Komponente I' auf den (-)-Eingang der ersten Differenzverstärkers 26 gegeben wird. In entsprechender Weise wird die Quadraturphase-Komponente Q des Eingangssignals dem (+)-Eingang eines zweiten Differenzverstärkers 27 zugeführt, während die rückgekoppelte Quadraturphase-Komponente Q' dem (-)-Eingang des zweiten Differenzverstärkers 27 zugeführt wird. Durch diese, allgemein als cartesian feedback bezeichnete Rückkopplungs-Anordnung wird erreicht, daß Linearisierungsfehler des Leistungsverstärkers 9 durch den in der Rückkopplungsschleife 16 angeordneten Quadraturdemodulators 19 und die Differenzverstärker 26 und 27 kompensiert werden. Dabei ist jedoch zu beachten, daß das rückgekoppelte Signal I',Q' den Differenzverstärkern 26 und 27 mit einer Phasenverschiebung von 0° gegenüber dem Eingangssignal I,Q zugeführt wird. Die richtige Phasenlage wird durch den verstellbaren Phasenverschieber 25 eingestellt, dessen Phasenwinkel φ durch den digitalen Signalprozessor über ein Steuersignal mit dem erfindungsgemäßen Verfahren veränderbar ist.

Da sowohl der Quadraturmodulator 3 als auch der Quadraturdemodulator 19 einen Gleichspannungsversatz (DCoffset) aufweisen, ist dieser Gleichspannungsversatz entsprechend zu kompensieren. Dazu dient ein dritter Differenzverstärker 28, der zwischen dem Inphase-Mischer 22 des Quadraturdemodualators 19 und dem ersten Verstärker 26 angeordnet ist. Ein vierter Differenzverstärker 29 ist zwischen dem Quadraturphase-Mischer 23 des Quadraturdemodulators 19 und dem zweiten Differenzverstärker 27 angeordnet. Während dem (+)-Eingang des dritten Differenzverstärkers 28 die rückgekoppelte Inphase-Komponente I' zugeführt wird, wird dem (-)-Eingang des dritten Differenzverstärkers 28 eine erste Abgleichspannung $V_{I1}$ zugeführt, so daß am Ausgang des dritten Differenzverstärkers 28 der Gleichspannungsversatz in der I'-Komponente des Quadraturdemodulators 19 kompensiert ist. In entsprechender Weise wird dem vierten Differenzverstärker 29 an dessen (+)-Eingang die rückgekoppelte Quadraturphase-Komponente Q' zugeführt, während dessen (-)-Eingang eine vierte Abgleichspannung $V_{Q1}$ zugeführt wird.

Um den Gleichspannungsversatz des Quadraturmodulators 3 zu kompensieren, dient ein fünfter Differenzverstärker 30, dessen (+)-Eingang der Ausgang des ersten Differenzverstärkers 26 zugeführt wird, während dessen (-)-Eingang eine dritte Abgleichspannung $V_{I2}$ zugeführt wird. Ferner ist ein sechster Differenzverstärker 31 vorgesehen, dessen Ausgang mit dem Quadraturphase-Mischer 5 des Quadraturmodulators 3 verbunden ist, und dessen (+)-Eingang der Ausgang des zweiten Differenzverstärkers 27 zugeführt ist. Dem (-)-Eingang des sechsten Differenzverstärkers 31 ist eine vierte Abgleichspannung $V_{Q2}$ zugeführt. Die Abgleichspannungen $V_{I1}$, $V_{Q1}$, $V_{I2}$ und $V_{Q2}$ sind in Fig. 1 als steuerbare Spannungsquellen zur besseren Veranschaulichung eingezeichnet, jedoch werden diese Abgleichspannungen zweckmäßigerweise intern in dem digitalen Signalprozessor 2 erzeugt.

Bei der schnellen Umschaltung zwischen Sendebetrieb und Empfangsbetrieb besteht bei Verwendung einer Rückkopplungsschleife 16 nach dem cartesian feedback Prinzip das Problem, daß der Hochfrequenz-Signalpfad der Schleife bestehend aus dem Quadraturmodulator 3, dem Leistungsverstärker 9, dem Quadraturdemodulator 19 und den Differenzverstärkern 26 und 27 beim Umschalten vom Sendebetrieb zum Empfangsbetrieb unterbrochen werden muß, da der Leistungsverstärker 9 und der lokale Oszillator 8 abgeschaltet werden müssen. Bei dem Wiedereinschalten des Leistungsverstärkers 9 und des lokalen Oszillators 8 und dem Wiederherstellen des Hochfrequenz-Signalpfades über die Rückkopplungsschleife 16 kommt es zu einem Schaltstoß, da die Spannungen des Regelsystems, also die Ausgangsspannungen der beiden Differenzverstärker 26, 27, bei geöffnetem Hochfrequenz-Signalpfad an den positiven oder negativen Regelanschlag laufen. Dies führt zu einem unzulässigen Leistungssprung auf die maximal mögliche Sendeleistung des Leistungsverstärkers 9. Deshalb sind in Fig. 1 neben dem Hochfrequenz-Signalpfad vom Ausgang der Differenzverstärker 26 und 27 über den Quadraturmodulator 3, den Leistungsverstärker 9 und den Quadraturdemodulator 19 zum (-)-Eingang der Differenzverstärker 26 und 27 zwei direkte Gleichstrom-Signalpfade 32 und 33 vorzusehen, die den Ausgang des jeweils zugeordneten Differenzverstärkers 26 bzw. 27 mit dem (-)-Eingang des jeweiligen Differenzverstärkers 26 bzw. 27 direkt verbinden. Die direkten Gleichstrom-Signalpfade 32 und 33 bestehen im dargestellten Ausführungsbeispiel jeweils aus einem steuerbaren Schalter 34 bzw. 35, die beispielsweise als Feldeffekt-Transistoren ausgebildet sein können, und einem in Serie geschalteten Widerstand 36 bzw. 37. Während des Empfangsbetriebs kann am Ein- und Ausgang des Differenzverstärkers 26 und 27 ein konstantes OV-Potential aufrechterhalten werden, so daß das Umschalten in den Sendebetrieb stoßfrei erfolgt. Die Funktion der parallel zu den Widerständen 36 und 37 angeordneten und über eine gesonderte Schalterstellung mit den Schaltern 34 und 35 verbindbaren niederohmigen Widerstände 51 und 52 wird später erläutert.

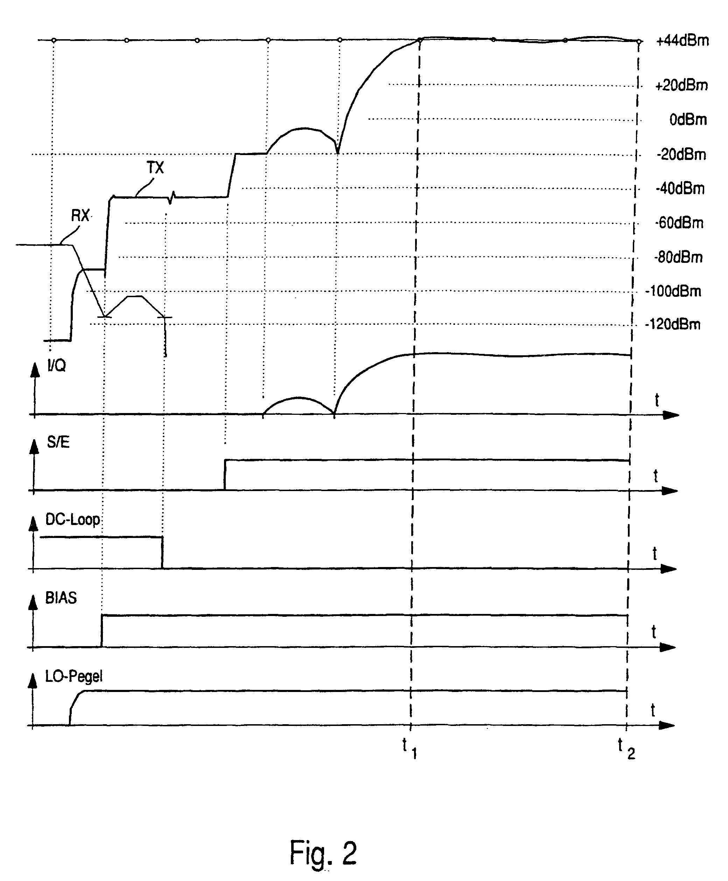

Fig. 2 zeigt in einem Zeitdiagramm den Ablauf des Umschaltens von dem Empfangsbetrieb in den Sendebetrieb. In dem obersten Teildiagramm ist die Ausgangsleistung TX als Funktion der Zeit logarithmisch dargestellt. In Fig. 2 ist ferner das Signal des spätestmöglichen Empfang-Intervalls dargestellt und mit RX bezeichnet. In dem darunterliegenden Teildiagramm ist das Eingangssignal I/Q als Funktion der Zeit dargestellt. Darunter befindet sich das Signal "S/E" zur Betätigung des Sende-Empfangsumschalters 12 und das Signal "DC-Loop" zur Betätigung der Schalter 34 und 35 jeweils als Funktion der Zeit t. Das Signal "BIAS" bezeichnet die Versorgungsspannung für den Leistungsverstärker 9, während das Signal "LO-Pegel" den Pegel des lokalen Oszillators 8 bezeichnet.

Wie aus Fig. 2 erkennbar, wird bei der Umschaltung vom Empfangsbetrieb in den Sendebetrieb wie folgt vorgegangen:

Zunächst wird der Pegel des lokalen Oszillators 8 erhöht. Dann wird die Versorgungsspannung (BIAS) für den Leistungsverstärker 9 zugeschaltet und anschließend der Schalter 17 betätigt, so daß der Eingang des Quadraturdemodulators 19 auf den Auskoppler 15 umgeschaltet wird. Nachdem somit die Hochfrequenz-Rückkopplungsschleife geschlossen ist, werden die Schalter 34 und 35 durch das Signal "DC-Loop" geöffnet und somit die Gleichstrom-Pfade 32 und 33 unterbrochen. Schließlich wird durch das Signal "S/E" der Sende-Empfangsumschalter 12 in dem Sendebetrieb umgeschaltet. Nachfolgend kann das Eingangssignal I/Q über die (+)Eingänge der Differenzverstärker 26 und 27 dem Quadraturmodulator 3 zugeführt werden und somit die Ausgangsleistung TX sukzessive erhöht werden (Ramping).

Im Zeitintervall zwischen den Zeitpunkten $t_1$ und $t_2$ steht ein nahezu konstantes Ausgangssignal zur Verfügung. Im Ausführungsbeispiel wird als Referenzsignal zwischen den Zeitpunkten $t_1$ und $t_2$ ein Eingangssignal I/Q verwendet, das aus einer konstanten Inphase-Komponente (I = const.) ohne Quadraturphase-Komponente (Q = 0) besteht. Dieses Signal wird zu Beginn eines jeden Sendeintervalls vor der Übertragung der eigentlichen Daten als Referenzsignal für eine Zeitdauer von vorzugsweise drei Datensymbolen im Zeitintervall zwischen $t_1$ und $t_2$ angelegt. Gleichzeitig wird zumindest die Quadraturphase-Komponente $V_{QM}$ an dem Meßpunkt 53 in Fig. 1 gemessen. Vorzugsweise wird auch die Inphase-Komponente $V_{IM}$ an dem Meßpunkt 61 gemessen. Da eine reine Inphase-Komponente ohne Quadraturphase-Komponente als Eingangssignal verwendet wird, ist das Meßsignal $V_{QM}$ an dem Meßpunkt 53 im Idealfall, d. h. bei richtig gewähltem Phasenwinkel φ für den Phasenschieber 25 Null. Tritt eine abweichende Meßspannung auf, so deutet dies auf einen Phasenfehler hin, welcher zu korrigieren ist.

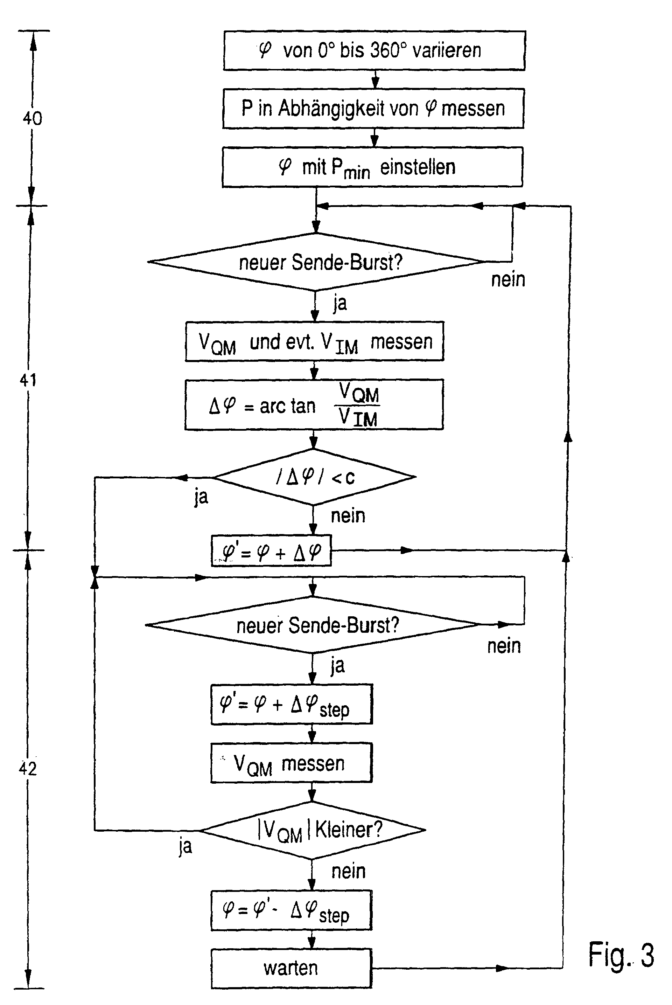

Anhand von Fig. 3 wird das erfindungsgemäße Verfahren zum Einstellen des Phasenwinkels φ erläutert. Das Verfahren gliedert sich in eine bei der Inbetriebnahme der Sendeeinrichtung 1 einmalig vorzunehmende Voreinstellung des Phasenwinkels φ (Verfahrensschritte 40), eine Nachstellung des Phasenwinkels φ bei jedem Sende-Intervall (Sende-Burst) (Verfahrensschritte 41) und eine optionale Feinnachstellung des Phasenwinkels φ bei jedem Sende-Intervall (Verfahrensschritte 42).

Bei der Inbetriebnahme der Sendeeinrichtung 1 wird der Phasenwinkel φ des Phasenschiebers 25 bei dem in Fig. 3 dargestellten Ausführungsbeispiels so voreingestellt, daß mit dem logarithmischen Leistungsdetektor 39 oder mit dem Leistungsdetektor 11 die Leistung P in Abhängigkeit von dem Phasenwinkel φ gemessen wird. Der Phasenwinkel φ wird dabei kontinuierlich im Bereich von 0° bis 360° variiert. Schließlich wird derjenige Phasenwinkel φ eingestellt, bei welchem die Messung die minimale Leistung $P_{min}$ ergeben hat. Dieses Meßprinzip beruht darauf, daß für den Phasenwinkel φ, für welchen sich die minimale Ausgangsleistung $P_{min}$ ergibt, davon auszugehen ist, daß die Rückkopplungsschleife 16 optimal gegengekoppelt ist. Der so voreingestellte Phasenwinkel φ bietet in der Regel einen guten Ausgangspunkt für das nachfolgend zu beschreibende Einstellverfahren, das bei jedem Sendeintervall vorgenommen wird. Während dieser Messung der Ausgangsleistung wird das Signal der Rückkopplungsschleife 16 gedämpft, um bei einer groben Fehleinstellung des Phasenwinkels φ eine zu große Mitkopplung mit der Gefahr der Zerstörung des Leistungsverstärkers 9 zu vermeiden. Im Ausführungsbeispiel wird diese Dämpfung dadurch erzielt, daß die Schalter 35 und 35 auf die niederohmigen Widerstände 51 und 52 umgeschaltet werden, um eine starke Gegenkopplung der Differenzverstärker 26 und 27 zu erzielen. Alternativ könnten z. B. auch Serienwiderstände in der Rückkopplungsschleife 16 zugeschaltet werden.

Bei dem erfindungsgemäßen Einstellverfahren wird wie beschrieben zu Beginn eines jeden Sende-Intervalls bzw. Sende-Burst für eine Zeitdauer von vorzugsweise drei Datensymbolen ein Referenzsignal mit einer reinen Inphase-Komponente (I = const.) ohne Quadraturphase-Komponente (Q = 0) angelegt und zumindest die Quadraturphase-Komponente (Meßsignal $V_{QM}$) am Ausgang des zweiten Differenzverstärkers 27 am Meßpunkt 53 gemessen. Da die Inphase-Komponente I konstant ist, genügt es, die gemessenen Quadraturphase-Komponente $V_{QM}$ mit der Eingangs-Inphase-Komponente I in Relation zu setzen und als Argument für die Arcus-Tangens-Funktion zu verwenden, um den Phasenkorrekturwert Δφ zu erhalten. Die Meßgenauigkeit kann erhöht werden, indem die gemessene Quadraturphase-Komponente $V_{QM}$ nicht mit der vorgegebenen Inphase-Komponente I am Eingang des ersten Differenzverstärkers 26, sondern mit der am Ausgang des ersten Differenzverstärkers 26 gemessenen Inphase-Komponente $V_{IM}$ in Relation gesetzt wird. Der korrigierte Phasenwinkel φ' ergibt sich dann durch Addition des Phasenkorrekturwinkels Δφ zu dem bisher eingestellten Phasenwinkel φ. Der Phasenkorrekturwert Δφ kann in einer gespeicherten Tabelle in Abhängigkeit von dem gemessenen Signal $V_{QM}$ bzw. $V_{QM}$ und $V_{IM}$ abgelesen werden.

Bei der in Fig. 3 beschriebenen Variante des Einstellverfahrens erfolgt das Nachstellen des Phasenwinkels φ mittels der Arcus-Tangens-Funktion nur so lange, als der erhaltene Phasenkorrekturwert Δφ größer als eine vorgegebene Konstante c ist. Wird der Phasenkorrekturwert Δφ kleiner als der Grenzwert c, so wird in ein iteratives Feineinstellverfahren 42 übergegangen. Dieses Feineinstellverfahren 42 beruht auf einem Versuchs- und Irrtum-Prinzip. Vor jedem Sende-Burst wird der aktuell eingestellte Phasenwinkel φ versuchsweise um eine Schrittweite $\Delta\varphi_{step}$ verändert und dann zu Beginn des Sende-Bursts die Meßspannung $V_{QM}$ am Meßpunkt 53 gemessen, während am Eingang eine reine Inphase-Komponente I ohne Quadraturphase-Komponente anliegt. Bei richtig eingestelltem Phasenwinkel φ ist die Meßspannung $V_{QM}$ idealerweise 0.

Verringert sich der Betrag $|V_{QM}|$ der Meßspannung $V_{QM}$ durch die Variation des eingestellten Phasenwinkels φ, ist dieser neue eingestellt Phasenwinkel φ'

besser als der bisher eingestellte Phasenwinkel φ. Ggf. wird der Phasenwinkel φ für den nächsten Sende-Burst nochmals in dieser Richtung verändert, um auszuprobieren, ob der Betrag der Meßspannung $V_{QM}$ dabei noch weiter abnimmt. Ggf. kann die Schrittweite in Abhängigkeit von dem Betrag der Meßspannung $V_{QM}$ variiert werden. Wird der Betrag der Meßspannung $V_{QM}$ jedoch größer, so wird auf den bisher eingestellten Phasenwinkel φ zurückgestellt.

Dieses Verfahren wird dann in die entgegengesetzte Richtung mit umgekehrtem Vorzeichen von $\Delta\varphi_{step}$ wiederholt werden. Ergibt auch die Feinverstellung in die entgegengesetzte Richtung keine Verbesserung, so ist der bisher eingestellte Phasenwinkel φ als optimaler Wert und wird für eine vorbestimmte Zeitdauer belassen. Nach einer Zeitdauer, nach welcher sich z. B. aufgrund einer thermischen Drift eine Verstellung des Phasenwinkels φ ergeben haben kann, wird das vorstehend beschriebene Verfahren wiederholt.

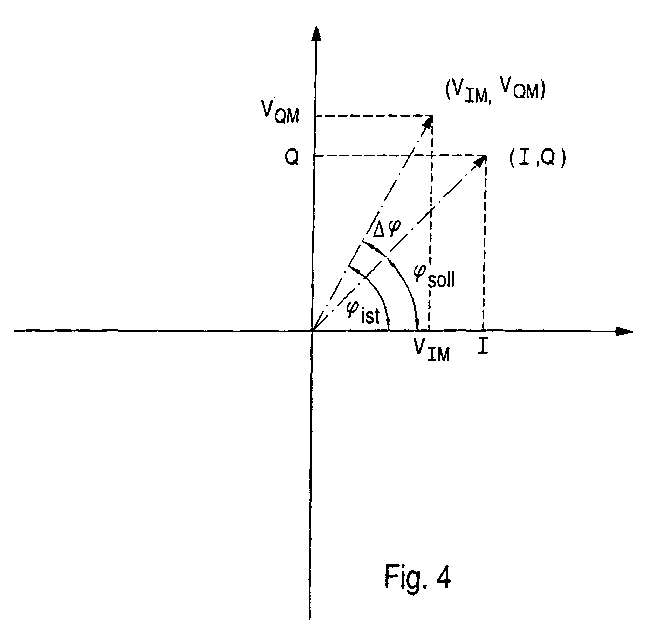

Fig. 4 zeigt das vorgegebene, konstante Eingangssignal (I, Q), bestehend aus der Inphase-Komponente I und der Quadraturphase-Komponente Q, und das am Ausgang der Differenzverstärker 26 und 27 gemessene Meßsignal ($V_{IM}$, $V_{QM}$), bestehend aus der gemessenen Inphase-Komponente $V_{IM}$ und der gemessenen Quadraturphase-Komponente $V_{QM}$.

Dabei ergibt sich der vorgegebene Soll-Phasenwinkel $\varphi_{soll}$ durch die Beziehung

$$\varphi_{soll} = \arctan \frac{Q}{I}.$$

Der gemessene Ist-Phasenwinkel $\varphi_{ist}$ ergibt sich durch die Beziehung

$$\varphi_{ist} = \arctan \frac{V_{QM}}{V_{IM}}.$$

Der Phasenkorrekturwert Δφ ergibt sich aus der Beziehung

$$\Delta\varphi = \varphi_{ist} - \varphi_{soll} =$$

$$= \arctan \frac{V_{QM}}{V_{IM}} - \arctan \frac{Q}{I}.$$

Bei dem anhand von Fig. 3 beschriebenen Ausführungsbeispiel wurde ein Eingangssignal mit einer reinen Inphase-Komponente verwendet, wobei die Eingangs-Quadraturphase-Komponente Q Null ist, so daß $\varphi_{soll}$ = 0 ist. Wie die vorstehende Beziehung zeigt, können jedoch auch andere Eingangssignale mit anderen Soll-Phasenwinkeln verwendet werden, wobei die Verwendung des Soll-Phasenwinkels $\varphi_{soll}$ = 0 wegen der sich ergebenden Vereinfachung des Meßverfahrens bevorzugt ist.

Die Erfindung ist nicht auf das dargestellte Ausführungsbeispiel beschränkt. Insbesondere können auch andere als in Fig. 3 dargestellte Algorithmen zum Einsatz kommen. Die in Fig. 3 dargestellte Voreinstellung des Phasenwinkels φ kann auch in anderer Weise vorgenommen werden. Statt eines Eingangssignals mit einer reinen Inphase-Komponente kann jedes beliebige Eingangssignal mit konstantem Phasenwinkel φ verwendet werden.

**Patentansprüche**

1. Verfahren zum Einstellen eines Phasenwinkels (φ) eines Phasenschiebers (25) einer Sendeeinrichtung (1),
   wobei die Sendeeinrichtung (1)
   einen Quadraturmodulator (3) zur Quadraturmodulation einer Inphase-Komponente (I) und einer Quadraturphase-Komponente (Q) eines komplexen Eingangssignals (I,Q),
   einen dem Quadraturmodulator (3) nachgeschalteten Leistungsverstärker (9),
   einen Quadraturdemodulator (19) zur Quadraturdemodulation des Ausgangssignals des Leistungsverstärkers (9) in eine rückgekoppelte Inphase-Komponente (I') und eine rückgekoppelte Quadraturphase-Komponente (Q'),
   einen dem Quadraturmodulator (3) vorgeschalteten ersten Differenzverstärker (26), dessen ersten Eingang die Inphase-Komponente (I) des Eingangssignals und dessen zweiten Eingang die rückgekoppelte Inphase-Komponente (I') zugeführt wird,
   einen dem Quadraturmodulator (3) vorgeschalteten zweiten Differenzverstärker (27), dessen ersten Eingang die Quadraturphase-Komponente (Q) des Eingangssignals und dessen zweiten Eingang die rückgekoppelte Quadraturphase-Komponente (Q') zugeführt wird, und
   einen Phasenschieber (25), der dem Quadraturdemodulator (19) ein Oszillatorsignal zuführt, das gegenüber einem Oszillatorsignal, das dem Quadraturmodulator (3) zugeführt wird, um den einzustellenden Phasenwinkel (φ) verschoben ist,
   aufweist,
   **gekennzeichnet durch**
   folgende Verfahrensschritte:

   - Anlegen eines Eingangssignals mit einer vorgegebenen, konstanten Inphase-Komponente (I) und eine vorgegebenen, konstanten Quadraturphase-Komponente (Q) bei jedem Sende-Intervall bei geschlossener Rückkopplungsschleife (16) bestehend aus Quadraturmodulator (3), Leistungsverstärker (9), Quadraturdemodulator (19) und erstem und zweitem Differenzverstärkern (26, 27),
   - Messen der Quadraturphase-Komponente (V$_{QM}$) und/oder der Inphase-Komponente (I$_{QM}$) an einem Meßpunkt (53; 61) hinter dem Ausgang der Differenzverstärker (26, 27),
   - Ermitteln einer Phasenkorrekturwertes (Δφ) auf der Basis der gemessenen Quadraturphase-Komponente (V$_{QM}$) und/oder der gemessenen Inphase-Komponente (V$_{IQ}$) und
   - Korrigieren des aktuell eingestellten Phasenwinkels (φ) des Phasenschiebers (25) **durch** Addieren oder Subtrahieren des ermittelten Phasenkorrekturwertes (Δφ) in einem Sendeunterbrechungs-Intervall.

2. Verfahren nach Anspruch 1,
   **dadurch gekennzeichnet,**
   **daß** das Anlegen eines Eingangssignals mit einer vorgegebenen Inphase-Komponente (I) ohne eine Quadraturphase-Komponente (Q=0) und das Messen der Quadraturphase-Komponente (V$_{QM}$) an dem Meßpunkt (53) hinter dem Ausgang des zweiten Differenzverstärkers (27) zu Beginn eines jeden Sendeintervalls erfolgt.

3. Verfahren nach Anspruch 2,
   **dadurch gekennzeichnet,**
   **daß** zusätzlich die Inphase-Komponente (V$_{IM}$) an dem Meßpunkt (61) hinter dem Ausgang des ersten Differenzverstärkers (26) gemessen wird.

4. Verfahren nach einem der Ansprüche 1 bis 3,
   **dadurch gekennzeichnet,**
   **daß** die Ermittlung des Phasenkorrekturwertes. (Δφ) gemäß folgender Berechnung erfolgt:

   $$\Delta\varphi = \arctan\frac{V_{QM}}{V_{IM}} - \arctan\frac{Q}{I}$$

   wobei V$_{QM}$ die gemessene Quadraturphase-Komponente,
   V$_{IM}$ die gemessene Inphase-Komponente,
   Q die vorgegebene Quadraturphase-Komponente und
   I die vorgegebene Inphase-Komponente ist.

5. Verfahren nach Anspruch 2 oder 3,
   **dadurch gekennzeichnet,**
   **daß** die Ermittlung des Phasenkorrekturwertes (Δφ) in der Weise erfolgt, daß
   der Phasenwinkel (φ) in eine erste Richtung um eine Schrittweite verändert wird, wenn die gemessene Quadraturphase-Komponente (V$_{QM}$) positiv ist, und
   der Phasenwinkel (φ) in die entgegengesetzte Richtung um eine Schrittweite verändert wird, wenn die gemessene Quadraturphase-Komponente (V$_{QM}$) negativ ist.

6. Verfahren nach Anspruch 5,
**dadurch gekennzeichnet,**
**daß** die Schrittweite vom dem Betrag der gemessenen Quadratur-Komponente ($V_{QM}$) abhängt.

7. Verfahren nach einem der Ansprüche 1 bis 6,
**dadurch gekennzeichnet,**
**daß** der Phasenwinkel ($\varphi$) nicht verändert wird wenn der Betrag der gemessenen Quadraturphase-Komponente ($V_{QM}$) kleiner als ein vorgegebener Grenzwert (c) ist.

8. Verfahren nach einem der Ansprüche 1 bis 7,
**dadurch gekennzeichnet,**
**daß** vor oder bei der Inbetriebnahme der Sendeeinrichtung eine Voreinstellung des Phasenwinkels ($\varphi$) des Phasenschiebers (25) in der Weise erfolgt, daß an einem dem Leistungsverstärker (9) nachgeschalteten Leistungsdetektor (10; 39) die Ausgangsleistung (P) gemessen wird und der Phasenwinkel ($\varphi$) so voreingestellt wird, daß sich ein Minimum ($P_{min}$) der Ausgangsleistung (P) ergibt.

## Claims

1. Method for adjusting a phase angle ($\phi$) of a phase modifier (25) of a transmitting device (1),
wherein the transmitting device (1) has
a quadrature modulator (3) for quadrature modulation of an inphase component (I) and a quadrature phase component (Q) of a complex input signal (I, Q),
a power amplifier (9), connected downstream the quadrature modulator (3),
a quadrature demodulator (19) for quadrature demodulation of the output signal of the power amplifier (9) into a fedback inphase component (I') and a fedback quadrature phase component (Q'),
a first differential amplifier (26), connected upstream the quadrature modulator (3), to the first input of which the inphase component (I) of the input signal and to the second input of which the fedback inphase component (I') are supplied,
a second differential amplifier (27), connected upstream the quadrature modulator (3), to the first input of which the quadrature phase component (Q) of the input signal and to the second input of which the fedback quadrature phase component (Q') are supplied and
a phase modifier (25), which supplies to the quadrature demodulator (19) an oscillator signal, shifted with regard to an oscillator signal supplied to the quadrature modulator (3) by the phase angle ($\phi$) to be adjusted,
**characterised by**
the following method steps:

- applying an input signal with a predetermined constant inphase component (I) and a predetermined constant quadrature phase component (Q) at each transmitting interval with closed feedback loop (16) consisting of quadrature modulator (3), power amplifier (9), quadrature demodulator (19) and first and second differential amplifiers (26, 27),
- measuring the quadrature phase component ($V_{QM}$) and/or the inphase component ($I_{QM}$) at a measuring point (53; 61) behind the output of the differential amplifiers (26, 27),
- determining a phase correction value ($\Delta\varphi$) on the basis of the measured quadrature phase component ($V_{QM}$) and/or the measured inphase component ($V_{IQ}$) and
- correcting the currently set phase angle ($\phi$) of the phase modifier (25) by adding or subtracting the determined phase correction value ($\Delta\varphi$) in a transmitting interruption interval.

2. Method according to claim 1,
**characterised in that** applying an input signal with a predetermined inphase component (I) without a quadrature phase component (Q=0) and measuring the quadrature phase component ($V_{QM}$) at measuring point (53) behind the output of the second differential amplifier (27) takes place at the beginning of every transmitting interval.

3. Method according to claim 2,
**characterised in that** additionally the inphase component ($V_{IM}$) is measured at measuring point (61) behind the output of the first differential amplifier (26).

4. Method according to one of claims 1 to 3,
**characterised in that** determining the phase correction value ($\Delta\varphi$) is done according to the following calculation:

$$\Delta\varphi = \arctan \frac{V_{QM}}{V_{IM}} - \arctan \frac{Q}{I}$$

wherein $V_{QM}$ is the measured quadrature phase component,
$V_{IM}$ the measured inphase component,
Q the predetermined quadrature phase component and
I the predetermined inphase component.

5. Method according to claim 2 or 3,
**characterised in that** determining the phase correction value ($\Delta\varphi$) is done in such a way that
the phase angle ($\phi$) is altered by a step width in a first direction if the measured quadrature phase component ($V_{QM}$) is positive and

the phase angle ($\phi$) is altered by a step width in the opposite direction if the measured quadrature phase component ($V_{QM}$) is negative.

6. Method according to claim 5,
   **characterised in that** the step width depends on the amount of the measured quadrature component ($V_{QM}$)

7. Method according to one of claims 1 to 6,
   **characterised in that** the phase angle ($\phi$) is not altered if the amount of the measured quadrature phase component ($V_{QM}$) is smaller than a predetermined limit value (c).

8. Method according to one of claims 1 to 7,
   **characterised in that** before or when the transmitting device is taken into operation preliminary adjustment of the phase angle ($\phi$) of the phase modifier (25) takes place in such a way that the output power (P) is measured at a power detector (10; 39) connected downstream the power amplifier (9) and the phase angle ($\phi$) is pre-adjusted in such a way that a minimum ($P_{min}$) of the output power (P) results.

**Revendications**

1. Procédé de réglage d'un angle de phase ($\varphi$) d'un déphaseur (25) d'un émetteur (1),
   l'émetteur (1) présentant
   un modulateur en quadrature (3) pour la modulation en quadrature d'une composante de phasage (I) et d'une composante de phase en quadrature (Q) d'un signal d'entrée complexe (I, Q),
   un amplificateur de puissance (9) monté en aval du modulateur en quadrature,
   un modulateur en quadrature (19) pour la modulation en quadrature du signal de sortie de l'amplificateur de puissance (9) en une composante de phasage de réaction (I') et en une composante de phase en quadrature de réaction (Q'),
   un premier amplificateur différentiel (26) monté en amont du modulateur en quadrature (3), à la première entrée duquel la composante de phasage (I) du signal d'entrée et à la seconde entrée duquel la composante de phasage de réaction(I') est amenée,
   un second amplificateur différentiel (27) monté en amont du modulateur en quadrature (3), à la première entrée duquel la composante en phase de quadrature (Q) du signal d'entrée et à la seconde entrée duquel la composante en phase de quadrature de réaction (Q') est amenée,
   un déphaseur (25) qui amène au démodulateur en quadrature un signal de l'oscillateur qui est décalé de l'angle de phase à régler ($\varphi$) par rapport à un signal de l'oscillateur qui est amené au modulateur en quadrature (3),
   **caractérisé par** les étapes de procédé suivantes:

   - application d'un signal d'entrée avec une composante de phasage constante prédéfinie (I) et une composante de phase en quadrature constante prédéfinie (Q) à chaque intervalle de mesure, lorsque que la boucle de réaction (16) composée d'un modulateur en quadrature (3), d'un amplificateur de puissance (9), d'un démodulateur en quadrature (19) et d'un premier et d'un second amplificateur différentiel (26, 27) est fermée,
   - mesure de la composante de phase en quadrature et/ou de la composante de phasage ($I_{QM}$) sur un point de mesure (53; 61), derrière la sortie des amplificateurs différentiels (26, 27),
   - recherche d'une valeur de correction de phase ($\Delta\varphi$), sur la base de la composante de phase en quadrature ($V_{QM}$) mesurée et/ou de la composante de phasage ($I_{QM}$) mesurée et
   - correction de l'angle de phase ($\varphi$) actuellement réglé sur le déphaseur (25), par addition ou par soustraction de la valeur de correction de phase recherchée ($\Delta\varphi$), au cours d'un intervalle d'interruption de l'émission.

2. Procédé selon la revendication 1,
   **caractérisé en ce que**,
   l'application d'un signal d'entrée avec une composante de phasage prédéfinie (I) sans composante de phase en quadrature (Q = 0) et la mesure de la composante de phase en quadrature ($V_{QM}$) ont lieu sur le point de mesure (53) derrière la sortie du second amplificateur différentiel (27), au début de chaque intervalle d'émission.

3. Procédé selon la revendication 2,
   **caractérisé en ce que**,
   la composante de phasage ($V_{IM}$) est mesurée en supplément sur le point de mesure (61) derrière la sortie du premier amplificateur différentiel (26).

4. Procédé selon l'une quelconque des revendications 1 à 3,
   **caractérisé en ce que**
   la recherche de la valeur de correction de phase ($\Delta\varphi$) est effectuée selon le calcul suivant:

$$(\Delta\varphi)=\arctan\frac{V_{QM}}{V_{IM}}-\arctan\frac{Q}{I}$$

   $V_{QM}$ étant la composante de phase en quadrature mesurée
   Q étant la composante de phase en quadrature prédéfinie,

I étant la composante de phasage prédéfinie.

5. Procédé selon la revendication 2 ou 3,
   **caractérisé en ce que**
   la recherche de la valeur de correction de phase $((\Delta\varphi))$ est effectuée de façon à ce que
   l'angle de phase $(\varphi)$ soit modifié d'un premier pas de progression dans une première direction, si la composante de phase en quadrature $(V_{QM})$ mesurée est positive et
   l'angle de phase $(\varphi)$ soit modifié d'un pas de progression dans la direction opposée si la composante de phase en quadrature $(V_{QM})$ mesurée est négative.

6. Procédé selon la revendication 5,
   **caractérisé en ce que**,
   le pas de progression dépend de la valeur de la composante en quadrature $(V_{QM})$ mesurée.

7. Procédé selon l'une quelconque des revendications 1 à 6,
   **caractérisé en ce que**,
   l'angle de phase $(\varphi)$ n'est pas modifié si la valeur de la composante de phase en quadrature mesurée $(V_{QM})$ est inférieure à une valeur limite (c) prédéfinie.

8. Procédé selon l'une quelconque des revendications 1 à 7
   **caractérisé en ce**
   **qu'**avant ou lors de la mise en service de l'émetteur, on procède à un préréglage de l'angle de phase $(\varphi)$ du déphaseur (25), de façon à ce que la puissance de sortie (P) soit mesurée sur un détecteur de puissance (10; 39) qui est monté en aval de l'amplificateur de puissance (9) et que l'angle de phase $(\varphi)$ soit préréglé de façon à ce qu'il en résulte un minimum $(p_{min})$ de la puissance de sortie.

Fig. 1

EP 1 216 559 B1

11

Fig. 2

$\varphi$ von 0° bis 360° variieren

P in Abhängigkeit von $\varphi$ messen

$\varphi$ mit $P_{min}$ einstellen

neuer Sende-Burst?   nein

ja

$V_{QM}$ und evt. $V_{IM}$ messen

$\Delta\varphi = \text{arc tan } \dfrac{V_{QM}}{V_{IM}}$

$/\Delta\varphi/ < c$

ja   nein

$\varphi' = \varphi + \Delta\varphi$

neuer Sende-Burst?   nein

ja

$\varphi' = \varphi + \Delta\varphi_{step}$

$V_{QM}$ messen

$|V_{QM}|$ Kleiner?

ja   nein

$\varphi = \varphi' - \Delta\varphi_{step}$

warten

40

41

42

Fig. 3

Fig. 4